Europäisches Patentamt

European Patent Office

Office européen des brevets

(11) Publication number: **0 342 794**
**A1**

## (12) EUROPEAN PATENT APPLICATION

(21) Application number: 89303769.7

(22) Date of filing: 17.04.89

(51) Int. Cl.⁴: **H03K 3/353 , H03K 3/023**

(30) Priority: **20.05.88 US 196647**

(43) Date of publication of application:
**23.11.89 Bulletin 89/47**

(84) Designated Contracting States:
**DE FR GB**

(71) Applicant: **DELCO ELECTRONICS
CORPORATION (a Delaware corp.)
700 East Firmin Street
Kokomo, Indiana 46902(US)**

(72) Inventor: **Hansen, Mark C.
1901 S Goyer Road 75
Kokomo Indiana 46902(US)**

(74) Representative: **Denton, Michael John et al
Patent Section - Luton Office (F6) Vauxhall
Motors Limited P.O. Box 3 Kimpton Road
Luton Bedfordshire LU2 0SY(GB)**

(54) Trigger circuit.

(57) A Schmitt trigger circuit that utilizes field effect transistors and which is fabricated as a very large scale integrated circuit. The trigger circuit includes a voltage comparator (10-18) which has two inputs (20,24) and an output (44). One of the inputs (20) is connected to a signal source (22) and the other input (24) is connected to trigger control voltages that have different magnitudes. The trigger control voltages are developed by a source of direct voltage (28,32) and a resistive voltage divider (80,82) connected to the voltage source. The trigger control voltages are applied to the voltage comparator (10-18) by N-channel and P-channel field effect transistors (70,72) which are biased alternately conductive in response to the magnitude of the output voltage of the voltage comparator (10-18).

FIG.3

EP 0 342 794 A1

## TRIGGER CIRCUIT

This invention relates to trigger circuits and more particularly to a Schmitt trigger circuit that utilizes metal oxide field effect transistors.

Schmitt triggers that use field effect transistors are known. In one type of known Schmitt trigger a voltage comparator is provided that has two inputs. An input signal is applied to one of the inputs and a trigger control voltage that varies, dependent upon the switching state of the trigger circuit, is applied to the other input of the voltage comparator. With this arrangement the Schmitt trigger exhibits a hysteresis characteristic; that is, the trigger circuit will switch state when the magnitude of the input signal exceeds a predetermined magnitude but will not switch back to its original switching state until the magnitude of the input signal drops to a value that is lower than the predetermined magnitude. This hysteresis characteristic provides noise immunity for the trigger circuit.

In known Schmitt trigger circuits, the variable trigger control voltage for one of the inputs of the voltage comparator can be provided by a voltage divider comprised of the series connection of two voltage divider resistors and an N-channel (field effect) transistor that are connected with a source of direct voltage. One of the inputs of the voltage comparator is connected to a junction of the voltage divider resistors. The arrangement is such that when the N-channel transistor is biased nonconductive the voltage at the junction has a certain magnitude and when the N-channel transistor is biased conductive the voltage at the junction drops to a lower value. The conductive or nonconductive state of the N-channel transistor depends upon the switching state of the trigger circuit. The trigger circuit can be modified such that two P-channel (field effect) transistors are substituted for the two voltage divider resistors. These P-channel transistors operate to provide a voltage divider function.

The trigger circuit that has just been described has certain problems when the N-channel transistor is conducting. Process variations in the manufacture of the N-channel transistor will cause the voltage drop Von of the conducting N-channel transistor to vary. This directly affects the value of the lower voltage switchpoint of the trigger circuit. Variations are further more pronounced where P-channel transistors are used instead of resistors since the conducting voltage drop of the P-channel transistors can vary independently of the conducting voltage drop of the N-channel transistor. In this regard, the processes for manufacturing the N-channel and P-channel transistors are not the same. It accordingly is preferred to use resistors in the voltage divider instead of the P-channel transistors but in order to keep the currents down, the physical size of the resistors might be very large. The size of the N-channel transistor must also be sized quite large whether resistors or P-channel transistors are used in the voltage divider to keep its conducting voltage drop Von to a low value.

It accordingly is an object of this invention to provide a trigger circuit that overcomes the problems set forth above that are associated with the use of the N-channel transistor and the voltage divider that is comprised of either resistors or P-channel transistors.

To this end, a trigger circuit in accordance with the present invention is characterised by the features specified in the characterising portion of claim 1.

In carrying this object forward the trigger circuit is arranged such that all active transistors are out of the current path that sets up the reference or trigger control voltage for the one input terminal of the voltage comparator. More specifically, a trigger circuit made in accordance with this invention uses a pair of voltage divider resistors connected to a source of direct voltage. The voltage divider resistors have a common junction the voltage of which is a function of the voltage divider ratio of the resistors. The trigger circuit further has a series connected P-channel and N-channel transistor which are switched, dependent upon the switching state of the trigger circuit. The arrangement is such that when the N-channel transistor is biased conductive the P-channel transistor is biased nonconductive and vice versa. The N- and P-channel transistors are so connected to one of the input terminals of the voltage comparator and to the common junction of the voltage divider and to the source of direct voltage that when the N-channel transistor is conducting it connects the common junction of the resistive voltage divider to the input terminal of the voltage comparator. When the P-channel transistor is conductive it connects the source of direct voltage directly to the input terminal of the voltage comparator.

The present invention will now be described, by way of example, with reference to the accompanying drawings, in which:-

Figure 1 is a schematic circuit diagram of a known Schmitt trigger circuit;

Figure 2 is a schematic circuit diagram of a known modification that can be made to the Schmitt trigger circuit of Figure 1; and

Figure 3 is a schematic circuit diagram of a Schmitt trigger circuit made in accordance with this invention.

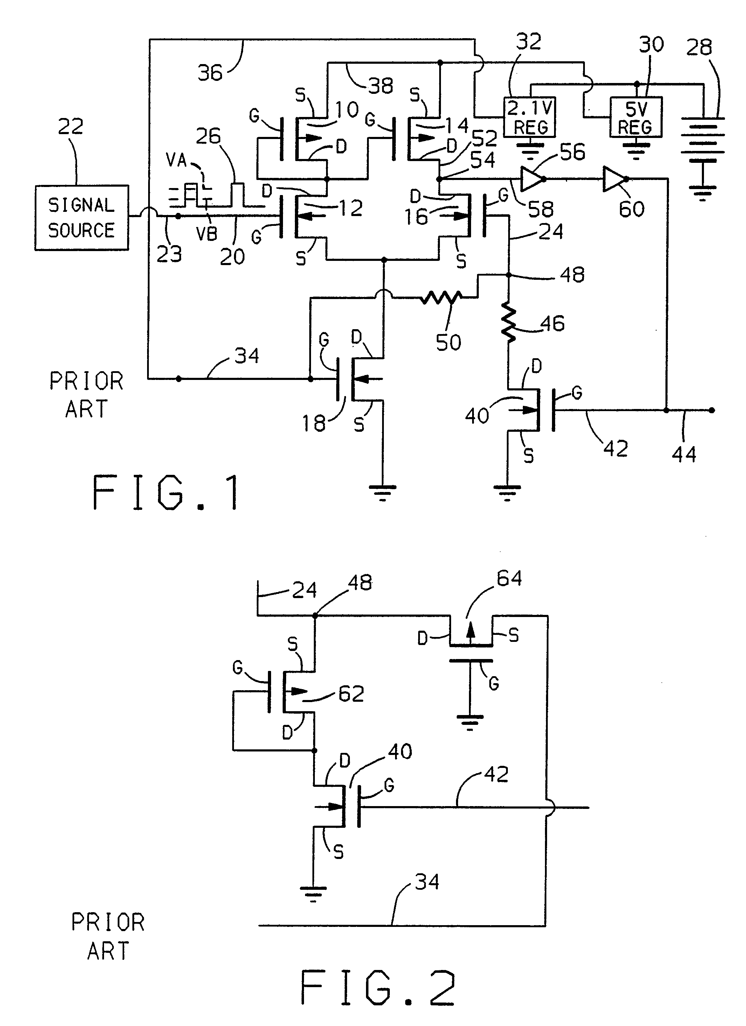

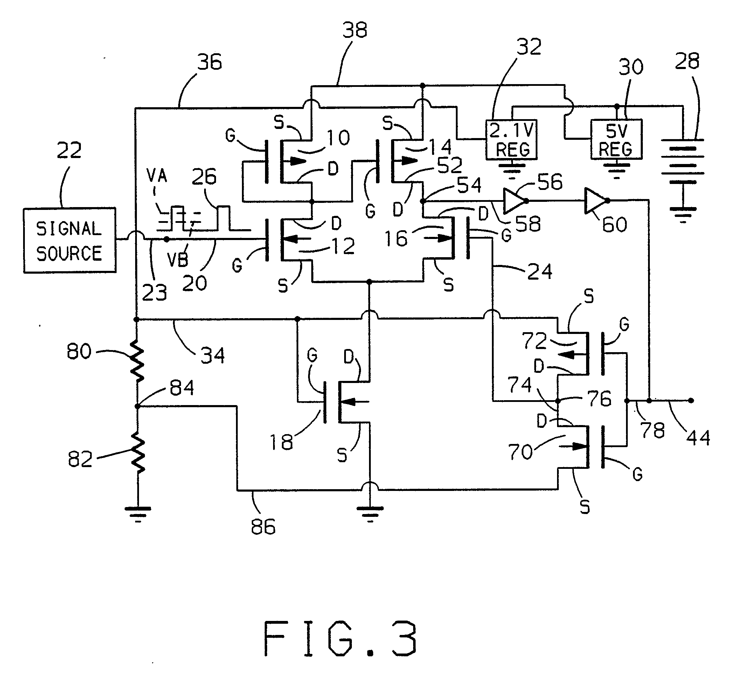

In describing this invention, which is shown in Figure 3, the known Schmitt trigger circuits of Figures 1 and 2 will be described first. After the Schmitt trigger circuits of Figures 1 and 2 are described the disadvantages of these circuits will be pointed out.

It is pointed out that all of the Schmitt trigger circuits to be described are manufactured or implemented as a CMOS very large scale integrated circuit or chip commonly known as a VLSI chip.

Referring now to the drawings and more particularly to Figure 1, the reference numeral 10 designates a (P-channel metal oxide field effect) transistor that has a gate G, a drain D and source S. Also shown in Figure 1 is an (N-channel metal oxide field effect) transistor 12 having a gate G, a drain D and a source S. Transistor 10 has an outwardly directed arrow to indicate that it is a P-channel transistor and transistor 12 has an inwardly directed arrow to indicate that it is an N-channel transistor. The remainder of the field effect transistors, to be described, likewise have arrow symbols to indicate whether the transistor is a P-channel or an N-channel.

The transistors 10 and 12, as well as transistors 14, 16 and 18, form a voltage comparator. A conductor or line 20, which is connected to the gate G of transistor 12, forms a first input for the voltage comparator. This conductor 20 is connected with a signal source 22 by conductor 23 and accordingly the conductor 20 is the signal source input to the voltage comparator. The voltage comparator has a second input on line or conductor 24 that is connected to the gate G of transistor 16. The transistors 10, 14 and 18 operate as current source transistors.

The signal source 22 develops a signal at its output which is shown as a square wave signal 26 (source output signal) that has a series of consecutively occurring pulses. The square wave signal 26 may be developed by a part of an electronic ignition system for an internal combustion engine and may be a spark timing signal. Two voltage levels, indicated by dotted lines VA and VB, are shown in Figure 1 for one of the square wave pulses. The Schmitt trigger will be switched to one state when the input signal is increasing and when its magnitude exceeds VA. The circuit will not switch to its other switching state until the input signal decreases to the VB level.

The direct voltage power supply for the Schmitt trigger comprises a direct voltage source 28 that is shown as a battery. The direct voltage source 28 may be, for example, a 12 volt storage battery on a motor vehicle. The direct voltage source 28 feeds a (five volt) regulator 30 and a (2.1 volt) regulator 32. The regulated 2.1 volt output of regulator 32 is applied to a conductor 34 of the Schmitt trigger by a conductor 36. The regulated five volt output of regulator 30 is applied to the source electrodes S of transistors 10 and 14 by conductor 38.

The Schmitt trigger has an N-channel transistor 40, the source of which is connected to ground. The gate G of N-channel transistor 40 is connected to a conductor 42 which in turn is connected to a line 44 which is the output of the trigger circuit. A resistor 46 is connected between the drain D of N-channel transistor 40 and a junction 48 that is connected to conductor 24. Another resistor 50 is connected between junction 48 and conductor 34.

The drain electrode D of transistor 14 is connected to the drain electrode D of transistor 16 by conductor 52 which is also connected to node or junction 54. The junction 54 is connected to the input of an inverter 56 by line 58. The output of inverter 56 is connected to the input of inverter 60 and the output of this inverter is connected to the (output) line 44 of the trigger circuit. The inverters 56,60 operate as buffers and also serve to square-up the output signal of the trigger circuit.

The operation of the trigger circuit shown in Figure 1 will now be described. The switchpoint of the voltage comparator will be determined by the voltage on conductor 24 that is connected to the gate G of transistor 16. When the input signal voltage on conductor 20 is less than the voltage on conductor 24 the voltage at junction 54 will go low as will the voltage on line 44. In this case transistor 16 is biased conductive. When the input signal voltage on conductor 20 is greater than the voltage on conductor 24, transistor 16 will be biased nonconductive, causing the voltage at junction 54 and (output) line 44 to go high.

The voltage at conductor 24 will vary, depending upon the switching state of the trigger circuit. Thus, when the output on line 44 is low, N-channel transistor 40 will be biased nonconductive so that there is no current path to ground through conductor 34 and resistors 50 and 46. The voltage at conductor 24 will be about equal to 2.1 volts that is applied to conductor 34 by regulator 32. This corresponds to the voltage level VA shown in Figure 1. When the output on line 44 goes high, N-channel transistor 40 is biased conductive. A voltage divider is now connected between conductor 34 and ground which is comprised of resistors 50 and 46 and conducting N-channel transistor 40. The voltage at junction 48 and conductor 24 will now drop to a value that is less than 2.1 volts. The voltage at junction 48 will now be related to the input voltage (2.1 volts) to the voltage drop across N-channel transistor 40 and the relative resistance values of resistors 50 and 46 that have a predetermined ratio. The values of resistors 50 and 46 and the voltage drop across N-channel transistor 40 can be selected such that when N-channel transistor 40 is conducting the voltage at conductor 24 will, for example, be 0.8 to 1.2 volts. This corresponds to voltage VB shown in Figure 1.

In summary, when an increasing input signal transition occurs that goes though VA the trigger circuit switches such that the output on line 44 goes from low to high and the voltage on conductor 24 goes from the 2.1 volt level to the lower voltage level. When a decreasing input signal transition occurs that goes through the lower voltage level VB the output on line 44 goes from high to low and the voltage at conductor 24 goes from the lower level back to the higher 2.1 volt level.

Figure 2 illustrates a modification that can be made to the trigger circuit of Figure 1. In Figure 2, only a portion of the Figure 1 circuit is illustrated and the same reference numerals have been used to identify corresponding parts. In Figure 2, P-channel transistors 62 and 64 have been substituted respectively for the resistors 46 and 50 that are used in the Figure 1 circuit. The P-channel transistors 62 and 64 provide a voltage divider circuit; that is, the voltage at junction 48 will be a function of the voltage drop across the P-channel transistors 62 and 64.

The disadvantages and problems associated with the trigger circuits of Figures 1 and 2 will now be described, keeping in mind that the trigger circuits are manufactured as VSLI chips. One of the problems associated with the circuits of Figures 1 and 2 arises when N-channel transistor 40 is conducting. Process variations in the manufacture of N-channel transistor 40 will cause the voltage drop Von of this N-channel transistor to vary. This directly affects the value of the lower switchpoint voltage VB of the trigger circuit. In the Figure 2 circuit the variation in switchpoint voltage is more pronounced since the voltage drops across the P-channel transistors 62 and 64 can vary independently of the voltage drop across the N-channel transistor 40 because different processes are used to manufacture N-channel and P-channel transistors. For this reason, the resistors 46 and 50, used in Figure 1, are preferred but in order to keep currents down, the physical size of the resistors 46 and 50 might be very large. N-channel transistor 40 must also be sized quite large in both circuits to keep its voltage drop Von to a low value.

The trigger circuit of this invention, which is shown in Figure 3, overcomes the problems associated with the circuits of Figures 1 and 2. The circuit of Figure 3 will now be described. The circuit of Figure 3 uses most of the components of the circuit of Figure 1 and the same reference numerals have been used in Figure 3 as were used in Figure 1 to identify corresponding circuit elements.

Referring now to Figure 3, it can be seen that the circuit has an N-channel (field effect) transistor 70 and P-channel (field effect) transistor 72. The drain D of P-channel transistor 72 is connected to the drain D of N-channel transistor 70 by conductor 74 which is also connected to junction or node 76. The junction 76 is connected to (input) conductor 24 of the voltage comparator. The gate electrodes G of N- and P-channel transistors 70 and 72 are connected to the (output) line 44 of the trigger circuit by line or conductor 78. Line 58 and conductor 78 thereby define coupling means coupled to line 44 and the gates G of N- and P-channel transistors 70,72.

The conductor 34 is supplied with 2.1 volts from the (2.1 volt) regulator 32. Connected between conductor 34 and ground is a voltage divider comprised of series connected resistors 80 and 82 that have a common junction or node 84. This junction 84 is connected to the source electrode S of N-channel transistor 70 via conductor or line 86. The conductor 34 that has 2.1 volts applied thereto is connected to the source electrode S of P-channel transistor 72. Direct voltage source 28 and voltage divider 80,82 thereby define developing means for developing first and second trigger control voltage that have different voltage magnitudes.

The operation of the trigger circuit shown in Figure 3 will now be described. The voltage comparator of Figure 3 is identical with the voltage comparator of Figure 1 and the voltage comparator of Figure 3 accordingly operates in the same manner as has been described in connection with the description of Figure 1. In Figure 3, the conductive or nonconductive states of N- and P-channel transistors 70 and 72 depends on the state of the output voltage on line 44. When the output voltage on line 44 goes high the gates G of N- and P-channel transistors 70 and 72 both go high via conductor 78 with the result that N-channel transistor 70 is biased conductive between its drain D and source S and P-channel transistor 72 is biased nonconductive. The voltage at junction 84 is now applied to the gate of transistor 16 via conducting N-channel transistor 70. The voltage drop across N-channel transistor 70 is virtually zero because of the high input impedance of the gate circuit of transistor 16. Putting it another way, there is only a very small current that passes through conducting N-channel transistor 70 because of the high input impedance of transistor 16 and accordingly the voltage applied to the gate G of transistor 16 will be substantially equal to the voltage at junction 84. The voltage at junction 84 corresponds to the lower switchpoint voltage VB which may be, for example, 0.8 to 1.2 volts.

When the output voltage on line 44 goes low, P-channel transistor 72 is biased conductive between its source S and drain D and N-channel transistor 70 is biased nonconductive. The voltage on conductor 34 (2.1 volts) is now applied to the gate G of transistor 16 via conducting P-channel transistor 72. The voltage drop across P-channel transistor 72 is virtually zero because of the high input impedance of transistor 16 so that the voltage applied to the gate G of transistor 16 is substantially equal to the voltage of conductor 34.

The circuit of Figure 3 overcomes the problems associated with the circuits of Figures 1 and 2. Thus, all active transistors of the Figure 3 circuit are out of the current path that sets up the reference trigger voltage that is applied to conductor 24. Thus, when P-channel transistor 72 is conductive and N-channel transistor 70 is nonconductive, there is relatively no current flowing through P-channel transistor 72 and the voltage drop across P-channel transistor 72 will be close to zero volts. Likewise, when N-channel transistor 70 is conductive and P-channel transistor 72 nonconductive there is relatively no current flowing through N-channel transistor 70 so that the voltage drop across N-channel transistor 70 will be close to zero volts.

N- and P-channel transistors 70 and 72 need to be sized to assure that they can quickly switch to provide the two trigger voltages VA and VB to conductor 24. This size, however, is much less than the size that is needed for the N-channel transistor 40 of the circuits of Figures 1 and 2. The sizing of resistors 80 and 82 is determined by the amount of current that can be handled by the voltage supply for conductor 34. This amount of current is typically large enough that the resistor sizes of resistors 80 and 82 can be small.

The voltage divider or ladder comprised of resistors 80 and 82 can be used to provide the trigger or reference voltages to more than one Schmitt trigger. Thus, the voltages at conductor 34 and junction 84 can be applied to a plurality of Schmitt trigger circuits that are identical to the single Schmitt trigger circuit shown in Figure 3.

## Claims

1. A trigger circuit which is switchable between first and second switching states in response to variations in amplitude of an input signal comprising, a voltage comparator (10-18) having first (20) and second (24) inputs and an output (44), a signal source (22) coupled to the first input, and having a source output signal (26) of varying magnitude, the voltage comparator being switched to a first state wherein the output (44) has an output signal of a first predetermined magnitude when the voltage applied to the first input (20) exceeds the voltage applied to the second input (24), the voltage comparator being switched to a second state wherein the output (44) has an output signal of a second predetermined magnitude that is lower than the first predetermined magnitude when the voltage applied to the first input (20) is lower than the voltage applied to the second input (24), and coupling means (58) coupled to the output (44), characterised by developing means (28,80,82) for developing first and second trigger control voltages that have different voltage magnitudes; by a first field effect transistor (72) operative when conductive to apply the first trigger control voltage to the second input (24); by a second field effect transistor (70) operative when conductive to apply the second trigger control voltage to the second input (24); and in that the coupling means (58,78) is also coupled to the gates G of the field effect transistors (70,72) and responsive to the magnitude of the output signal for causing the field effect transistors to be biased alternately conductive.

2. A trigger circuit according to claim 1, wherein the developing means comprises a source of direct voltage (28,32) and a voltage divider comprised of a plurality of resistors (80,82) connected to the source of direct voltage.

3. A trigger circuit according to claim 1 or claim 2, wherein one of the field effect transistors is a P-channel transistor (72) and the other field effect transistor is an N-channel transistor (70).

4. A trigger circuit as claimed in claim 3, wherein the first trigger control voltage is a first positive direct voltage having a first magnitude, wherein the second trigger control voltage is a second positive direct voltage that has a magnitude that is less than the first magnitude, wherein the P-channel transistor (72) has its source (S) connected to the first positive direct voltage and has its drain (D) connected to the second input (24) of the voltage comparator (10-18), wherein the N-channel transistor (70) has its source (S) connected to the second positive direct voltage and has its drain (D) connected to the second input (24) of the voltage comparator, and wherein the coupling means (58,78) is coupled to the gates (G) of the P-and N-channel transistors.

5. A trigger circuit according to claim 4, wherein the second positive direct voltage is developed by a voltage divider that is comprised of a plurality of series connected resistors (80,82), the voltage divider being connected across a source (28,32) of direct voltage.

FIG.1

PRIOR ART

FIG.2

PRIOR ART

FIG.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 581 545 (R. G. BEALE et al.)<br>* column 1, lines 25-55; figure 1;<br>column 1, line 66 - column 2, line 38;<br>figure 2; column 2, line 39 - column 3,<br>line 19; column 4, lines 26-35 * | 1,2 | H 03 K    3/353<br>H 03 K    3/023 |
| A | --- | 3-5 | |
| X | ELECTRONIC DESIGN<br>vol. 31, no. 25, December 1983, Waseca,<br>MN, Denville, NY, US; P. HAM et al.:<br>"Digital CMOS cell library adopts<br>analog circuits", pages 107-112, 114 *<br>page 109, figure 1b * | 1,2 | |
| A | idem<br>--- | 3-5 | |
| A | PATENT ABSTRACTS OF JAPAN<br>vol. 8, no. 256 (E-280) (1693), 22<br>November 1984; & JP - A - 59128820<br>(SUWA SEIKOSHA K.K.), 25.07.1984<br>--- | 1 | |
| A | PATENT ABSTRACTS OF JAPAN<br>vol. 10, no. 306 (E-446) (2362), 17<br>October 1986; & JP - A - 61120515 (NEC<br>CORP), 07.06.1986<br>--- | 1 | TECHNICAL FIELDS SEARCHED (Int. Cl.4)<br><br>H 03 K    3/023<br>H 03 K    3/353 |
| A | PATENT ABSTRACTS OF JAPAN<br>vol. 9, no. 270 (E-353) (1993), 26<br>October 1985; & JP - A - 60116222<br>(NIPPON DENKI K.K.), 22.06.1985<br>--- | 3 | |
| A | RESEARCH DISCLOSURE<br>no. 267, July 1986, Emsworth,<br>Hamsphire, GB; "CMOS Hysteresis<br>Receiver", page 379 * figure *<br>---                                    -/- | 1 | |

The present search report has been drawn up for all claims

| Place of search | Date of completion of the search | Examiner |
|---|---|---|
| BERLIN | 15-06-1989 | ARENDT M |

European Patent
Office

**EUROPEAN SEARCH REPORT**

Application Number

EP  89 30 3769

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| P,A | US-A-4 775 807 (E. R. BUKOWSKI) <br> * figure 2; abstract * <br> --- | 1 | |
| X | PATENT ABSTRACTS OF JAPAN <br> vol. 8, no. 84 (E-239) (1521), 18 April 1984; & JP - A - 59004220 (MITSUBISHI DENKI K. K.), 11.01.1984 | 1,2 | |
| A | idem <br> ----- | 3,5 | |
| | | | TECHNICAL FIELDS SEARCHED (Int. Cl.4) |

The present search report has been drawn up for all claims

| Place of search | Date of completion of the search | Examiner |
|---|---|---|
| BERLIN | 15-06-1989 | ARENDT M |

EPO FORM 1503 03.82 (P0401)